Europäisches Patentamt

**European Patent Office**

**Office européen des brevets**

(11) Veröffentlichungsnummer: **0 337 171 B1**

(12) **EUROPÄISCHE PATENTSCHRIFT**

(45) Veröffentlichungstag der Patentschrift: **23.06.93**

(21) Anmeldenummer: **89105188.0**

(22) Anmeldetag: **23.03.89**

(51) Int. Cl.⁵: **G01R 27/02**, G01R 27/28

(54) **Verfahren zur kontaktlosen Messung eines im Sekundärkreis eines Überträgers angeordneten Widerstandes und Vorrichtung zur Durchführung des Verfahrens.**

(30) Priorität: **15.04.88 DE 3812633**

(43) Veröffentlichungstag der Anmeldung:
**18.10.89 Patentblatt 89/42**

(45) Bekanntmachung des Hinweises auf die
Patenterteilung:
**23.06.93 Patentblatt 93/25**

(84) Benannte Vertragsstaaten:
**ES FR GB IT SE**

(56) Entgegenhaltungen:
**AT-B- 274 133**
**CH-A- 466 869**

(73) Patentinhaber: **Daimler-Benz Aktiengesell-schaft**
**Postfach 600202 Mercedesstrasse 136**
**W-7000 Stuttgart 60(DE)**

(72) Erfinder: **Kaminski, Detlef**
**Daimler Strasse 18**
**W-7014 Kornwestheim(DE)**
Erfinder: **Schmitfranz, Bernd**
**Weizenstrasse 8**
**W-73 Esslingen(DE)**
Erfinder: **Adomat, Rolf**
**Friedrichshafener Strasse 39**
**W-7997 Immenstaad(DE)**
Erfinder: **Ulke, Walter**
**Moltkestrasse 34**
**W-7990 Friedrichshafen 1(DE)**
Erfinder: **Voigt, Burkhard**
**Dr.-Zimmermann-Strasse 8**
**W-7997 Immenstaad(DE)**

Rank Xerox (UK) Business Services
(3. 10/3.6/3.3. 1)

**Beschreibung**

Die Erfindung betrifft ein Verfahren zur kontaktlosen Messung eines im Sekundärkreis eines Übertragers angeordneten Widerstandes und eine Vorrichtung zur Durchführung des Verfahrens.

Aus der US-PS 4,242,631 ist eine Meßkopfeinrichtung für Meßgeräte bekannt, mit deren Hilfe komplexe Impedanzen unter weitgehender Verhinderung einer Meßwertverfälschung durch Anschlußimpedanzen meßbar sind. Sie benutzt einen Vergleichswiderstand, auf den die zu messende Impedanz bezogen wird. Als solche ist sie für Dreidraht- und Vierdrahtmessungen in der Trägerfrequenztechnik geeignet. Die Abgabe eines wenigstens einem bestimmten Widerstandswert zugeordneten Signals ist nicht vorgesehen.

Aus der CH-PS 466,869 ist eine Anordnung zur galvanisch getrennten, kontaktlosen Messung des absoluten Wertes von Impedanzen bekannt. Sie benutzt einen Oszillator mit Antriebs- und Rückkopplungswicklung, letztwelcher auch ein die Meßgröße repräsentierendes Signal entnommen wird. Zwischen beiden Wicklungen ist eine Meßwicklung bzw. Meßschlaufe angeordnet, die mit der zu messenden Impedanz abgeschlossen ist. Je nach Größe dieser Impedanz wird den von der Antriebswicklung ausgehenden, die Meßwicklung durchdringenden Feldlinien der Durchgriff in die Rückkopplungswicklung verwehrt; in entsprechender Weise verändert sich auch das von einer nachfolgenden Verstärkerstufe bereitstellbare Meßsignal. Um die am beweglichen Objekt angebrachte Impedanz messen zu können, muß die Meßwicklung so geformt und darf relativ zu den beiden anderen Wicklungen des Transformators nur so beweglich sein, daß die magnetische Flußverkettung im Rückkopplungsweg unverändert bleibt. Ein entsprechender Transformator ist deshalb sehr präzise zu fertigen und entsprechend teuer.

Des weiteren ist bekannt, zur Erkennung beispielsweise des Kurzschlußzustandes eines Signalhornschalters und zur Ansteuerung eines aufprallabsorbierenden Airbags im Lenkrad eines Kraftfahrzeuges vier Kontaktstifte und vier Schleifringe vorzusehen, die Bestandteile entsprechender Auslösestromkreise sind. Die Kontaktstifte werden mittels Federkraft auf die Schleifringe gedrückt. Dabei entstehen bei jeder Lenkbewegung Schleifgeräusche, die bei zunehmenden Geräuschdämpfungsbestrebungen im Kraftfahrzeuginnenraum als störend empfunden werden.

Im Lenkrad eines Kraftfahrzeuges ist der Bauraum allgemein beschränkt, insbesondere dann, wenn ein Airbag-System im Lenkrad untergebracht ist. Daher ist es erforderlich, so wenig Bauteile wie möglich im Lenkrad unterzubringen. Bei der Verwendung eines Airbag-Systems, das im Notfall sofort einsatzbereit sein muß, erweist sich zudem eine ständige Überprüfung der Funktionsfähigkeit als notwendig. Zu diesem Zweck wird der Widerstandswert der Zündkapsel, der im Bereich von 1.8 Ohm bis 2.5 Ohm liegen soll, einer stetig wiederkehrenden Messung unterzogen. Der dabei verwendete Meßstrom darf 30 mA nicht überschreiten.

Die Übertragung entsprechender Impedanzsignale mittels induktiv gekoppelter Spulen ist vom Abstand der beiden Spulen zueinander abhängig. Dabei muß berücksichtigt werden, daß auf Grund von Einbau- und Fertigungstoleranzen die Kopplungseigenschaften des Übertragers nicht festliegen und somit die üblichen Verfahren zur Widerstandsbestimmung mit Hilfe von Strom- und Spannungsmessung nicht die gewünschte Meßgenauigkeit erreichen.

Bisher verwendete Verfahren beschränkten sich auf die Messung der Amplitude der Antwort auf ein eingeleitetes Erregungssignal. Der Anwender ist gezwungen, immer einen konstanten und korrekten Spulenabstand einzuhalten. Dies ist aber in der Praxis nicht immer möglich, da beispielsweise in der Werkstatt beim Aus- und Einbau eines Lenkrades nicht auf Bruchteile von mm genau gearbeitet werden kann.

Aufgabe der Erfindung ist es, ein Verfahren anzugeben, mit dem Signale, insbesondere zwischen sich drehenden und feststehenden Teilen, wie Lenkrädern und Lenksäulen oder sonstigen Bauteilen in Kraftfahrzeugen, weitgehend unabhängig von beengenden Einbauvorschriften sicher und geräuschlos übertragen werden können und möglichst wenig Bauteile auf der Sekundärseite eines Übertragers, also im Lenkrad, vorhanden sind.

Diese Aufgabe wird durch ein gattungsgemäßes Verfahren mit den kennzeichnenden Merkmalen des Anspruchs 1 gelöst. Vorteilhafte Weiterbildungen des Verfahrens sind nach Lehre der Unteransprüche 2 bis 8 gegeben.

Weiter ist es Aufgabe der Erfindung, eine Vorrichtung zur Durchführung des Verfahrens vorzuschlagen.

Diese Aufgabe wird bei einer Vorrichtung mit den kennzeichnenden Merkmalen des Anspruchs 9 gelöst. Vorteilhafte Weiterbildungen sind nach Lehre der rückbezogenen Ansprüche 10 bis 15 gegeben.

Zwei einander gegenüberstehende, induktiv gekoppelte Spulen im drehbaren Lenkrad bzw. im feststehenden Fahrzeugchassis bilden einen Übertrager, der die Signalhornbetätigung und die Energieübertragung zur Zündung des Airbags im Falle eines Unfalls ermöglicht. Gleichzeitig ist die ständige Überprüfung des Airbag-Systems über den Übertrager möglich. Auf der Sekundärseite des Übertragers befindet sich ein Bauelement, beispielsweise hier die Zündkapsel des Airbags, dessen Widerstand von der Primärseite des Übertragers aus bestimmt werden soll.

Die Erfindung wird anhand von Figuren näher erläutert.

Es zeigen:

Figur 1    eine Prinzipschaltungsskizze des Übertragers,

Figur 2    die Darstellung der Antwortspannungsverläufe bei drei verschiedenen Widerständen und

Figur 3    die Darstellung der Antwortspannungsverläufe bei verschiedenen Spulenabständen,

Figur 4    eine Prinzipschaltungsskizze mit zwei parallelen Schaltkreisen,

Figur 5    die Darstellung von Erregung und Resonanzantwort bei zwei Schaltkreisen.

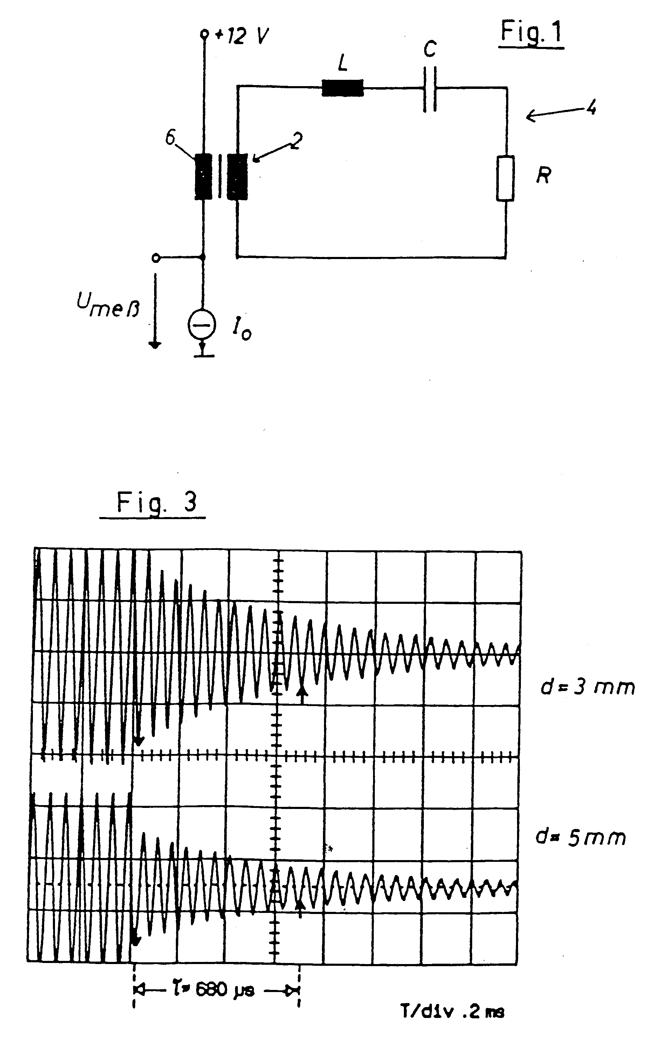

In Figur 1 wird über den Übertrager 2 der sekundärseitige LCR-Serienschwingkreis 4 kurzzeitig mit einem Stromimpuls, beispielsweise einer begrenzten Anzahl von Sinusschwingungen, angeregt. Danach wird die Primärseite 6 des Übertragers 2 hochohmig abgeschlossen, so dass der Übertrager 2 nur noch die Wirkung einer in Serie geschalteten Induktivität zur Spule L hat.

Im Schwingkreis bildet sich eine gedämpfte Schwingung aus. Die Dämpfung wird nur durch die Grössen R' und L' bestimmt und ist unabhängig von der Übertragerkopplung. Ein Abbild dieser gedämpften Schwingung kann auf der Primärseite des Übertragers abgegriffen werden. Dabei gilt als Gleichung für die Spannung:

$$U(t) = \hat{U}_0 \cdot \exp\left(-t\,\frac{R'}{2L'}\right) \cdot \sin(\omega_0 t) \quad \text{mit } \omega_0 = \sqrt{\frac{1}{LC} - \frac{R^2}{4L^2}}$$

Die Zeitkonstante

$$\tau = \frac{2 \cdot L'}{R'}$$

ist ein Maß für die zu bestimmende Grösse des sekundären Widerstands, die unabhängig von den Kopplungseigenschaften des Übertragers gewonnen werden kann.

Der verwendete Schwingkreis kann je nach Meßerfordernissen seriell oder parallel aufgebaut sein. Ebenfalls ist denkbar, die Induktivität L aus dem Schwingkreis herauszunehmen und die Induktivität der Übertragersekundärseite allein zu verwenden.

Zur elektronischen Bestimmung der Zeitkonstanten $\tau$ können verschiedene bereits bekannte Verfahren zur Anwendung kommen:

- Abtastung des Scheitelwertes $\hat{U}_0$ der Antwort und Zählen der Schwingungen bis zum Erreichen einer vorgegebenen Schwelle

$$\frac{\hat{U}_0}{m}$$

beispielweise

$$\frac{\hat{U}_0}{2}$$

- Abtastung des Scheitelwertes $\hat{U}_0$ der Antwort und Abtastung des Scheitelwertes $\hat{U}_1$ nach einem definierten Zeitintervall T; die Information über $\tau$ und R ist im Ausdruck $\hat{U}_1/\hat{U}_0$ enthalten
- Bildung der Hüllkurve der Antwort und Vermessen des Zeitintervalls zwischen zwei definierten Schranken.

Die Erfindung wird anhand von zwei Meßbeispielen weiter verdeutlicht:

3

Beispiel 1:

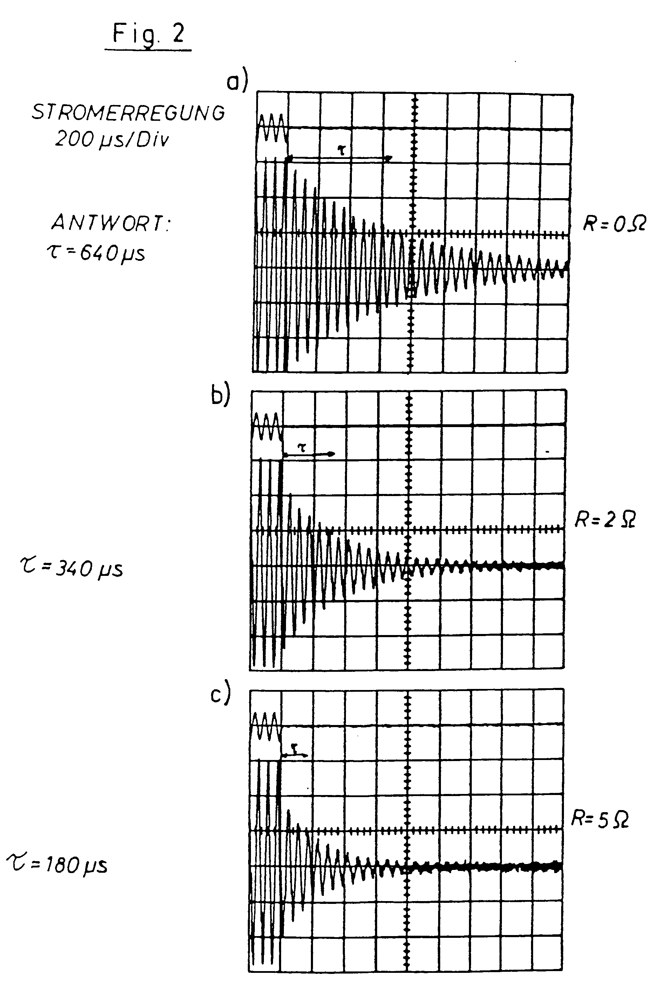

Bestimmung des Spannungsverlauf $U_{meß}(t)$ bei kurzzeitiger Erregung und konstantem Kopplungsfaktor ü des Übertragers. Hierbei wird der sekundärseitige Widerstand variiert. Figur 2 zeigt die Spannungsverläufe für drei Widerstände von 0 Ohm, 2 Ohm und 5 Ohm. Darin sind die Zeitkonstanten beim Abklingen bis zu einer vorgegebenen Amplitudenhöhe zu erkennen, die gemessen werden können. Mit zunehmendem Widerstand wird die Dämpfung grösser und die Zeitkonstante kleiner. In der Zeitkonstanten $\tau$ der abklingenden Sinusfunktion ist die Information über die Grösse des Sekundärwiderstandes R enthalten. Der effektive Sekundärwiderstand L' setzt sich aus der Induktivität L und der Induktivität des Übertragers $L_{ü}$ zusammen und beträgt im Beispiel etwa 1 mH. Die Grösse R' ergibt sich aus der Reihenschaltung aus R und der ohmschen Widerstände $R_s$ des Übertragers und der Induktivität L. $R_s$ beträgt in vorliegendem Beispiel etwa 3 Ohm.

Im oberen Bereich der Abbildungen ist die in den Übertrager eingeleitete Stromerregung bis zu ihrem Abschaltzeitpunkt zu erkennen. Bei einer Induktivität von L = 820 $\mu$H und einer Kapazität von C = 100 nF ergaben sich für die Widerstände von 0 Ohm, 2 Ohm und 5 Ohm die Zeitkonstanten $\tau$ = 640 $\mu$s, 340 $\mu$s und 180 $\mu$s.

Beispiel 2:

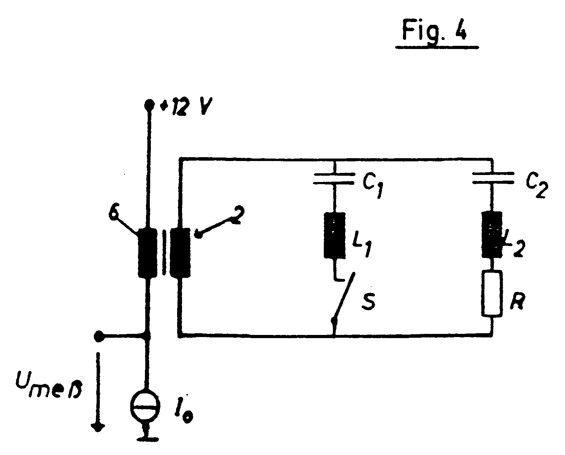

Bei dem Übertrager wurde der effektive Luftspalt verändert. Die sich dabei ergebenden Amplitudenmaximalwerte sind in Figur 3 dargestellt. Der obere Verlauf ergab sich bei ca. 3 mm Luftspalt und der untere bei ca. 5 mm Luftspalt. Die sich durch den veränderten Luftspalt ergebenden unterschiedlichen Kopplungsfaktoren führen zu einer Änderung der Amplitude, aber zu keiner erkennbaren Veränderung der ermittelten Zeitkonstante $\tau$.

Das beschriebene Verfahren kann bei allen Widerstandsmessungen vorteilhaft eingesetzt werden, bei denen Potentialtrennung, Berührungsfreiheit und/oder hohe Zuverlässigkeit, hier erreicht durch die Verwendung nur weniger Bauteile, geboten sind.

Eine Vorrichtung zur Durchführung dieses Verfahrens besteht aus einem Transformator, an den primärseitig eine Stromerregereinrichtung und ebenfalls primärseitig eine Auswerteeinrichtung für die Zeitkonstante der Erregerantwort nach Abschalten des Erregersignals angeschlossen ist. Sekundärseitig ist an den Transformator ein LCR-Schwingkreis angeschlossen, bei dem das R der Widerstand eines zu messenden Bauelements ist. Solche Bauelemente können Schalter, Sensoren, Widerstandsdrähte oder ähnliches sein.

Wird die Vorrichtung beispielsweise zur Übertragung von Signalen bei relativ zueinander rotierenden Teilen verwendet, so sind die Spulen frei zueinander beweglich und kreisförmig ausgebildet.

Derartige Signale bei rotierenden Bauteilen, wie Lenkrädern oder Rädern, können beispielsweise im Kraftfahrzeug die Auslösung des Signalhornschalters, die Überprüfung oder die Auslösung eines Airbag-Systems oder die Überprüfung des Reifenluftdrucks sein.

Neben der Auswertung des Widerstandes eines einzigen Bauteils ist auch die gemeinsame Auswertung der Widerstände mehrerer Bauteile möglich. Dies ist am Beispiel der Auswertung von Airbag und Signalhorneinrichtung gezeigt.

Figur 4 zeigt die Sekundärseite der Übertragungseinrichtung, hier das Lenkrad, die in zwei parallele Schaltkreise aufgeteilt ist. Dabei ist R der Widerstand der Zündkapsel und S der Auslöseschalter des Signalhorns.

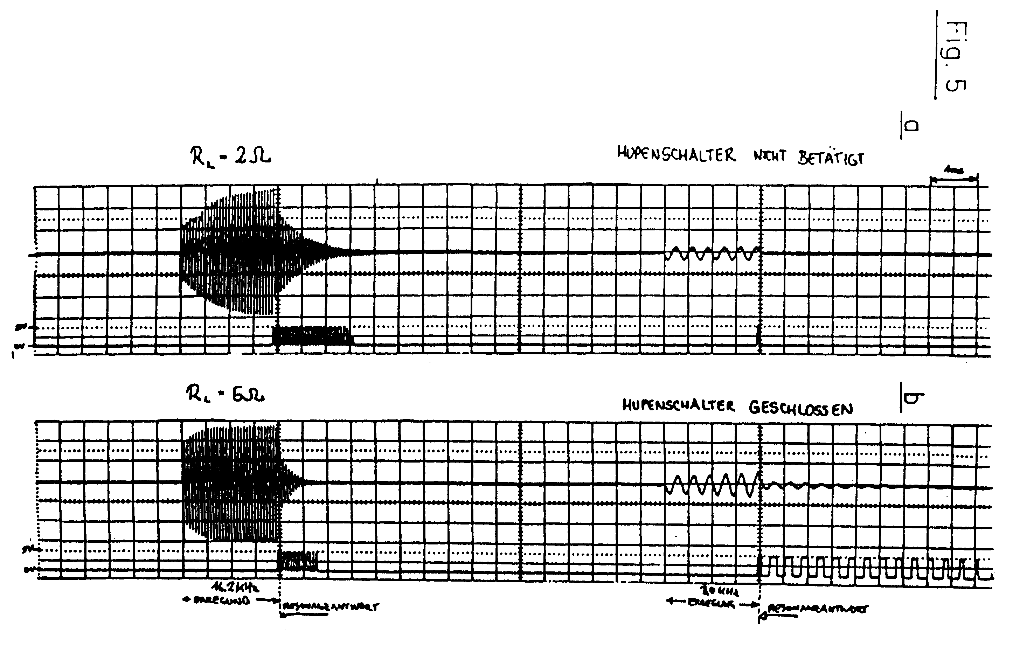

Die Figur 5 zeigt den periodisch wiederkehrenden Ablauf eines Auswerteschritts.

In Figur 5a wird zunächst im linken Bildteil der Schaltkreis des Airbagsystems mit einer Erregerfrequenz von 16.2 kHz angeregt. Dann wird die Erregung abgeschaltet und aus der Resonanzantwort der Widerstandswert, hier R = 2 Ohm, bestimmt. Der Schaltkreis, in dem sich der Signalhornschalter befindet, ist bei dieser Frequenz hochohmig.

Einige ms später wird eine andere Erregerfrequenz von ca. 3 kHz verwendet, bei der der Schaltkreis des Airbags hochohmig ist. Im rechten Teil der Figur 5a bei nicht betätigtem Signalhornschalter erfolgt nach Abstellen der Erregung keine Resonanzantwort.

Diese Einspeisung der verschiedenen Frequenzen erfolgt periodisch.

In Figur 5b wird im Airbagsystem ein anderer Widerstand verwendet, R = 5 Ohm, das aus der veränderten Resonanzantwort zu erkennen ist. Im rechten Teil der Figur ist die Auswirkung eines geschlossenen Signalhornschalters aufgezeigt. Aus der Resonanzantwort ist die Auslösung des Signalhornschalters zu erkennen. Dies wird von der Auswerteschaltung entsprechend detektiert und führt zur Auslösung des Signalhorns.

In gleicher Weise können auch mehrere unterschiedliche Schaltkreise ausgewertet werden, wobei die Schaltkreise jeweils mit unterschiedlichen Frequenzen angeregt werden.

**Patentansprüche**

1. Verfahren zur kontaktlosen Messung eines im Sekundärkreis eines Übertragers (2) mit induktiv gekoppelten Spulen angeordneten Widerstandes (R,S) bei einem Kraftfahrzeug,
   **dadurch gekennzeichnet**,
   - daß ein mit dem zu messenden Widerstand (R, S) verbundener LC-Schwingkreis auf der Sekundärseite des Übertragers (2) von der Primärseite (6) aus angeregt wird,
   - daß das Erregungssignal dann abgebrochen wird,
   - daß die abklingende Erregungsantwort auf die Primärseite (6) zückübertragen wird und
   - daß dort über die Zeitkonstante der Erregungsantwort der Wert des Widerstandes (R,S) ermittelt wird.

2. Verfahren nach Anspruch 1,
   **dadurch gekennzeichnet**,
   - daß der sekundärseitige Schwingkreis mit unterschiedlichen Frequenzen angeregt wird.

3. Verfahren nach Anspruch 1,
   **dadurch gekennzeichnet**,
   - daß das Verfahren ohne aktive Elektronik auf der Sekundärseite angewendet wird.

4. Verfahren nach Anspruch 1,
   **dadurch gekennzeichnet**,
   - daß das Verfahren unabhängig von den Kopplungseigenschaften der Spulen verwendet wird.

5. Verfahren nach Anspruch 1,
   **dadurch gekennzeichnet**,
   - daß der Scheitelwert $\hat{u}_o$ der Erregungsantwort abgetastet wird und die Schwingungen bis zum Erreichen einer Schwelle $\hat{u}_o/m$ gezählt werden.

6. Verfahren nach Anspruch 1,
   **dadurch gekennzeichnet**,
   - daß der Scheitelwert $\hat{u}_o$ der Erregungsantwort und der Scheitelwert $\hat{u}_1$ nach einem definierten Zeitintervall T abgetastet werden.

7. Verfahren nach Anspruch 1,
   **dadurch gekennzeichnet**,
   - daß die Hüllkurve der Erregungsantwort gebildet wird und das Zeitintervall zwischen zwei definierten Schranken vermessen wird.

8. Verfahren nach Anspruch 1,
   **dadurch gekennzeichnet**,
   - daß im Übertrager (2) kreisförmige Spulen verwendet werden.

9. Vorrichtung zur Durchführung des Verfahrens nach Anspruch 1,
   **dadurch gekennzeichnet**,
   - daß ein Transformator mit Luftspalt zwischen Primär- und Sekundärwicklung vorhanden ist;
   - daß an die Sekundärwicklung ein erster LC-Schwingkreis zusammen mit dem zu messenden Widerstand (R, S) angeschlossen ist;
   - daß die Primärwicklung an eine Erregerstromeinrichtung angeschlossen und von dieser mit einem Erregungssignal periodisch beaufschlagbar ist; und
   - daß die Primärwicklung mit einer Auswerteeinrichtung zur Vermessung der Primärspannung nach Abschalten des Erregungssignals verbunden ist.

10. Vorrichtung nach Anspruch 9,
    **dadurch gekennzeichnet**,

- daß der Transformator voneinander unabhängig bewegliche, relativ zueinander rotierbare Spulen umfaßt.

**11.** Vorrichtung nach Anspruch 10,
**dadurch gekennzeichnet**,
- daß die Spulen kreisförmig sind.

**12.** Vorrichtung nach Anspruch 10,
**dadurch gekennzeichnet**,
- daß der Transformator zwischen Lenkrad und Chassis eines Fahrzeuges zur elektrisch verbindungsfreien Signalhornauslösung und/oder Überprüfung und Auslösung von Airbag-Systemen vorgesehen ist.

**13.** Vorrichtung nach Anspruch 9,
**dadurch gekennzeichnet**,
- daß parallel zum ersten Schwingkreis ein oder mehrere weitere LC-Schwingkreise an die Sekundärwicklung anschaltbar sind, wobei in dem oder in den weiteren Schwingkreisen jeweils ein zu messender Widerstand (R, S) liegt.

**14.** Vorrichtung nach Anspruch 9,
**dadurch gekennzeichnet**,
- daß die primärseitig angeschlossene Auswerteeinrichtung eine Einrichtung zur Feststellung von Schwingungszeitkonstanten ist.

**15.** Vorrichtung nach Anspruch 13,
**dadurch gekennzeichnet**,
- daß die primärseitige Auswerteeinrichtung mit einer Einrichtung zur Signalgabe verbunden ist.

**Claims**

**1.** Method for the contactless measuring of a resistance (R, S) arranged in the secondary circuit of a transformer (2) with inductively coupled coils in a motor vehicle, characterised in that
- a resonant LC circuit which is connected to the resistance (R, S) to be measured on the secondary side of the transformer (2) is excited from the primary side (6),
- that the excitation signal is then interrupted,
- that the decaying excitation response is transferred back to the primary side (6) and
- that there the value of the resistance (R, S) is determined via the time constant of the excitation response.

**2.** Method according to Claim 1, characterised in that
- the secondary-side resonant circuit is excited at different frequencies.

**3.** Method according to Claim 1, characterised in that
- the method is used without active electronics on the secondary side.

**4.** Method according to Claim 1, characterised in that
- the method is used independently of the coupling characteristics of the coils.

**5.** Method according to Claim 1, characterised in that
- the peak value $\hat{u}_o$ of the excitation response is sampled and the oscillations are counted until a threshold $\hat{u}_o/m$ is reached.

**6.** Method according to Claim 1, characterised in that the peak value $\hat{u}_o$ of the excitation response and the peak value $\hat{u}_1$ after a defined time interval T are sampled.

**7.** Method according to Claim 1, characterised in that the envelope curve of the excitation response is formed and the time interval between two defined limits is measured.

**8.** Method according to Claim 1, characterised in that circular coils are used in the transformer (2).

**9.** Device for carrying out the method according to Claim 1, characterised in that a transformer with airgap between the primary and secondary winding is present;
- that, together with the resistance (R, S) to be measured, a first resonant LC circuit is connected to the secondary winding;
- that the primary winding is connected to an exciter current device and that an excitation signal can be periodically applied to it by the latter; and
- that the primary winding is connected to an analysing device for measuring the primary voltage after the excitation signal has been turned off.

**10.** Device according to Claim 9, characterised in that the transformer comprises coils which can be rotated relative to one another and can be moved independently of one another.

**11.** Device according to Claim 10, characterised in that the coils are circular.

**12.** Device according to Claim 10, characterised in that the transformer is provided between the steering wheel and chassis of a vehicle for the electrically connection-free triggering of the signalling horn and/or checking and triggering of airbag systems.

**13.** Device according to Claim 9, characterised in that
- in parallel with the first resonant circuit, one or several further resonant LC circuits can be connected to the secondary winding, a resistance (R, S) to be measured being in each case located in the further resonant circuit or circuits.

**14.** Device according to Claim 9, characterised in that the analysing device connected to the primary side is a device for determining oscillation time constants.

**15.** Device according to Claim 13, characterised in that the primary-side analyzing device is connected to a device for signal transmission.

**Revendications**

**1.** Procédé de mesure sans contact, dans un véhicule, d'une résistance (R, S) disposée dans un circuit secondaire d'un transformateur (2) à bobines couplées de façon inductive,
    **caractérisé en ce que**
- un circuit oscillant LC disposé sur le côté secondaire du transformateur (2), et relié à la résistance (R, S) à mesurer, est excité par le côté primaire (6),
- le signal d'excitation est ensuite interrompu,
- la réponse d'excitation décroissante est renvoyée au côté primaire (6) et
- la valeur de la résistance (R, S) y est déterminée au moyen de la constante de temps de la réponse d'excitation.

**2.** Procédé selon la revendication 1,
    **caractérisé en ce que**
- le circuit oscillant du côté secondaire est excité à différentes fréquences.

**3.** Procédé selon la revendication 1,
    **caractérisé en ce que**
- le procédé est utilisé sans électronique active sur le côté secondaire.

**4.** Procédé selon la revendication 1,
    **caractérisé en ce que**
- le procédé est utilisé de façon indépendante des propriétés de couplage des bobines.

**5.** Procédé selon la revendication 1,
    **caractérisé en ce que**

- la valeur de crête $\hat{u}_0$ de la réponse d'excitation est lue et les oscillations sont comptées jusqu'à ce que soit atteint un seuil $\hat{u}_0/m$.

6. Procédé selon la revendication 1,
   **caractérisé en ce que**
   - la valeur de crête $\hat{u}_0$ de la réponse d'excitation et la valeur de crête $\hat{u}_1$ sont lues après un intervalle de temps défini T.

7. Procédé selon la revendication 1,
   **caractérisé en ce que**
   - l'enveloppante de la réponse d'excitation est déterminée et l'intervalle de temps entre deux limites définies est mesuré.

8. Procédé selon la revendication 1,
   **caractérisé en ce que**
   - des bobines circulaires sont utilisées dans le transformateur (2).

9. Dispositif de mise en oeuvre du procédé selon la revendication 1,
   **caractérisé en ce que**
   - un transformateur à lame d'air est disposé entre l'enroulement primaire et l'enroulement secondaire;
   - un premier circuit oscillant LC est raccordé sur l'enroulement secondaire avec la résistance à mesurer (R, S);
   - l'enroulement primaire est raccordé à un dispositif de courant d'excitation et ce dernier peut lui appliquer périodiquement un signal d'excitation; et
   - l'enroulement primaire est relié à un dispositif d'évaluation pour mesurer la tension primaire après interruption du signal d'excitation.

10. Dispositif selon la revendication 9,
    **caractérisé en ce que**
    - le transformateur contient des bobines mobiles indépendamment l'une de l'autre, pouvant tourner l'une par rapport à l'autre.

11. Dispositif selon la revendication 10,
    **caractérisé en ce que**
    - les bobines sont circulaires.

12. Dispositif selon la revendication 10,
    **caractérisé en ce que**
    - le transformateur est prévu entre le volant de direction et le châssis d'un véhicule en vue d'un déclenchement d'un avertisseur à signal sonore et/ou d'une vérification et d'un déclenchement de sac pneumatique sans liaison électrique.

13. Dispositif selon la revendication 9,
    **caractérisé en ce que**
    - un ou plusieurs autres circuits oscillants LC peuvent être raccordés au circuit secondaire en parallèle avec le premier circuit oscillant, une résistance à mesurer (R, S) étant située dans l'autre ou les autres circuits oscillants respectivement.

14. Dispositif selon la revendication 9,
    **caractérisé en ce que**
    - le dispositif d'évaluation raccordé sur le côté primaire est un dispositif de détermination de constantes de temps d'oscillations.

15. Dispositif selon la revendication 13,
    **caractérisé en ce que**
    - le dispositif d'évaluation du côté primaire est relié à un dispositif d'émission de signaux.

Fig. 1

Fig. 3

$d = 3\,mm$

$d = 5\,mm$

$\tau = 680\ \mu s$

T/div .2 ms

# Fig. 2

a)

STROMERREGUNG
200 µs/Div

ANTWORT:
$\tau = 640\,\mu s$

$\tau$

$R = 0\,\Omega$

b)

$\tau$

$R = 2\,\Omega$

$\tau = 340\,\mu s$

c)

$\tau$

$R = 5\,\Omega$

$\tau = 180\,\mu s$

Fig. 4

Fig. 5